# EUROPEAN PATENT APPLICATION

(11) **EP 4 066 659 A1**
(43) Date of publication of application: **05.10.2022**
(21) Application number: 20893712.8
(22) Date of filing: 25.11.2020
(51) Int. Cl.: A24F 40/40, A24F 40/51

(54) **POWER UNIT FOR AEROSOL GENERATION DEVICE, MAIN BODY UNIT FOR AEROSOL GENERATION DEVICE, AEROSOL GENERATION DEVICE, AND NON-COMBUSTION-TYPE INHALER**

(30) Priority: 28.11.2019 JP 2019215759
(71) Applicant: Japan Tobacco Inc., Tokyo 105-6927 (JP)
(72) Inventor: MATSUDA, Kentaro, Tokyo 130-8603 (JP); YAMADA, Manabu, Tokyo 130-8603 (JP)
(74) Representative: Hoffmann Eitle
(86) International application number: PCT/JP2020/043847
(87) International publication number: WO 2021/106940

(57) **Abstract**

A power source unit (21) includes a battery (33), a flexible printed board (34) that is electrically connected to the battery, a sensor (39) mounted on the flexible printed board, and a housing (31) accommodating at least the battery, the flexible printed board, and the sensor. The flexible printed board has a perpendicular disposition portion (100) disposed in a manner of being substantially perpendicular to a longitudinal direction of the housing. The sensor (39) is mounted in the perpendicular disposition portion.

## Description

### [Technical Field]

The present invention relates to a power source unit of an aerosol generation device, a main body unit of an aerosol generation device, an aerosol generation device, and a non-combustion-type aspirator. This application is based upon and claims the benefit of priority from Japanese Patent Application No. 2019-215759, filed November 28, 2019, the content of which is incorporated herein by reference.

### [Background Art]

In the related art, non-combustion-type aspirators for savoring an aroma by aspirating a vapor (for example, aerosol) that has been atomized through heating (which will hereinafter be simply referred to as an aspirator) are known. An example of an aspirator of this kind includes an atomization unit which accommodates contents (for example, an aerosol source) that can be atomized, for example, and a power source unit in which a battery is mounted.

In the aspirator, a heating portion provided in the atomization unit generates heat by means of electric power supplied from the battery. Accordingly, the contents inside the atomization unit are atomized. A user can aspirate atomized aerosol together with air through the suction port portion of the atomization unit.

For example, Patent Document 1 discloses a power source unit in which an electronic circuit board is accommodated inside a slender shell.

### [Citation List]

### [Patent Literature]

[Patent Document 1]
Published Japanese Translation No. 2017-506901 of the PCT International Publication

### [Summary of Invention]

### [Technical Problem]

In the technology in the related art described above, the electronic circuit board is oriented in a manner of being practically parallel to a central axis of the shell. A pressure sensor is attached to the electronic circuit board. For this reason, the power source unit has an elongated overall length, which leads to increase in size of the device.

An object of the present invention is to provide a power source unit of an aerosol generation device, a main body unit of an aerosol generation device, an aerosol generation device, and a non-combustion-type aspirator, in which miniaturization of the device can be achieved.

### [Solution to Problem]

A power source unit of an aerosol generation device according to an aspect of the present invention includes a power source portion, a flexible printed board that is electrically connected to the power source portion, a sensor that is mounted on the flexible printed board, and a housing that accommodates at least the power source portion, the flexible printed board, and the sensor. The flexible printed board has a perpendicular disposition portion which is disposed in a manner of being substantially perpendicular to a longitudinal direction of the housing. The sensor is mounted in the perpendicular disposition portion.

According to the present aspect, the flexible printed board has the perpendicular disposition portion which is disposed in a manner of being substantially perpendicular to the longitudinal direction of the housing, and the sensor is mounted in the perpendicular disposition portion. Therefore, the dimension of the housing in the longitudinal direction can be shortened. Accordingly, not only miniaturization of the device but also space-saving inside the housing and improvement of easiness in assembly of the components can be achieved.

In the foregoing power source unit of an aerosol generation device, in the perpendicular disposition portion, a pin electrode may be mounted on a second face on a side opposite to a first face on which the sensor is mounted.

According to the present aspect, the pin electrode is mounted on a side opposite to the sensor utilizing the perpendicular disposition portion. Therefore, both the components can be closely disposed, and thus miniaturization of the device can be better achieved.

In the foregoing power source unit of an aerosol generation device, the sensor may be a pressure sensor. The housing may have an end wall supporting the pin electrode. A ventilation port penetrating the housing in the longitudinal direction may be formed in the end wall.

According to the present aspect, since the distance between the pin electrode and the sensor (the pressure sensor) is short, the ventilation port is formed in the end wall supporting the pin electrode. Therefore, sensitivity of the sensor can be improved.

The foregoing power source unit of an aerosol generation device may further include a frame member that forms a pressure variation chamber communicating with the ventilation port in a gap between the end wall and the perpendicular disposition portion.

According to the present aspect, the frame member forms the pressure variation chamber in the gap between the end wall and the perpendicular disposition portion. Therefore, the dimension of the pressure variation chamber in the longitudinal direction of the housing can be shortened, and thus miniaturization of the device can be better achieved.

In the foregoing power source unit of an aerosol generation device, a connection port penetrating the housing in the longitudinal direction and spatially connecting the pressure variation chamber and the sensor to each other may be formed in the perpendicular disposition portion.

According to the present aspect, since the connection port penetrating the housing in the longitudinal direction is formed in the perpendicular disposition portion, the pressure variation chamber and the sensor can be connected to each other over a short distance. Accordingly, the sensitivity of the sensor can be improved.

The foregoing power source unit of an aerosol generation device may further include a support member that is disposed on the first face side of the perpendicular disposition portion and supports at least a part of a rear surface region of the pin electrode.

According to the present aspect, a pushing reaction force of the pin electrode can be received by the support member supporting the rear surface region of the flexible perpendicular disposition portion.

The foregoing power source unit of an aerosol generation device may further include a charging terminal for charging the power source portion, and a substrate that is accommodated in the housing. The power source portion, the sensor, the charging terminal, and the substrate may be electrically connected to the flexible printed board.

According to the present aspect, the flexible printed board plays a role of a wiring for connecting the components to each other. Therefore, there is no need to install many conductor lines inside the housing. Accordingly, space-saving inside the housing and improvement of easiness in assembly of the components can be achieved.

In the foregoing power source unit of an aerosol generation device, the perpendicular disposition portion may be disposed on a first end portion side of the housing in the longitudinal direction. The charging terminal may be disposed on a second end portion side of the housing in the longitudinal direction. The flexible printed board may extend from one end portion side to the second end portion side of the housing in the longitudinal direction.

According to the present aspect, the components can be connected to each other with one flexible printed board from the first end portion side to the second end portion side of the housing in the longitudinal direction.

A main body unit of an aerosol generation device according to another aspect of the present invention includes the foregoing power source unit of an aerosol generation device, and an accommodation portion that is able to accommodate an atomization unit which is electrically connected to the power source unit.

According to the present aspect, replacement of the atomization unit, supplementation of an aerosol source, and the like can be easily performed by an operation of attaching and detaching the atomization unit with respect to the accommodation portion. Since the miniaturized power source unit is provided, miniaturization of the device in its entirety can also be achieved.

In the foregoing main body unit of an aerosol generation device, the accommodation portion may be an outer housing accommodating the housing of the power source unit or a part of the housing of the power source unit.

According to the present aspect, replacement of the atomization unit, supplementation of an aerosol source, and the like can be easily performed by an operation of attaching and detaching the atomization unit with respect to a part of the housing of the power source unit or the outer casing.

An aerosol generation device according to another aspect of the present invention includes the foregoing main body unit of an aerosol generation device, and an atomization unit that is accommodated in the accommodation portion of the main body unit and is electrically connected to the power source unit.

According to the present aspect, since the miniaturized power source unit is provided, miniaturization of the device in its entirety can be achieved.

A non-combustion-type aspirator according to another aspect of the present invention includes the foregoing aerosol generation device, and an aroma source container that is mounted in a suction port portion of the aerosol generation device.

According to the present aspect, an aroma can be added to aerosol passing through an aspiratory port.

### [Advantageous Effects of Invention]

According to the aspects of the present invention, miniaturization of the aerosol generation device and the non-combustion-type aspirator can be achieved.

### [Brief Description of Drawings]

Fig. 1 is a front view of an aspirator according to an embodiment.
Fig. 2 is a rear view of the aspirator according to the embodiment.
Fig. 3 is a right side view of the aspirator according to the embodiment.
Fig. 4 is a left side view of the aspirator according to the embodiment.
Fig. 5 is a plan view of the aspirator according to the embodiment.
Fig. 6 is a bottom view of the aspirator according to the embodiment.
Fig. 7 is an exploded perspective view of the aspirator according to the embodiment viewed from a bottom surface side.
Fig. 8 is an exploded perspective view of the aspirator according to the embodiment viewed from a flat surface side.
Fig. 9 is a cross-sectional constitution diagram of the aspirator according to the embodiment.
Fig. 10 is a front view of an aroma source container according to the embodiment.
Fig. 11 is a rear view of the aroma source container according to the embodiment.
Fig. 12 is a right side view of the aroma source container according to the embodiment.
Fig. 13 is a left side view of the aroma source container according to the embodiment.
Fig. 14 is a bottom view of the aroma source container according to the embodiment.
Fig. 15 is a longitudinal cross-sectional view of a power source unit according to the embodiment.
Fig. 16 is an exploded perspective view of the power source unit according to the embodiment.
Fig. 17 is a longitudinal cross-sectional view of a first end portion side of the power source unit according to the embodiment in a longitudinal direction.

### [Description of Embodiment]

Hereinafter, an embodiment of the present invention will be described on the basis of the drawings.

### [Aspirator]

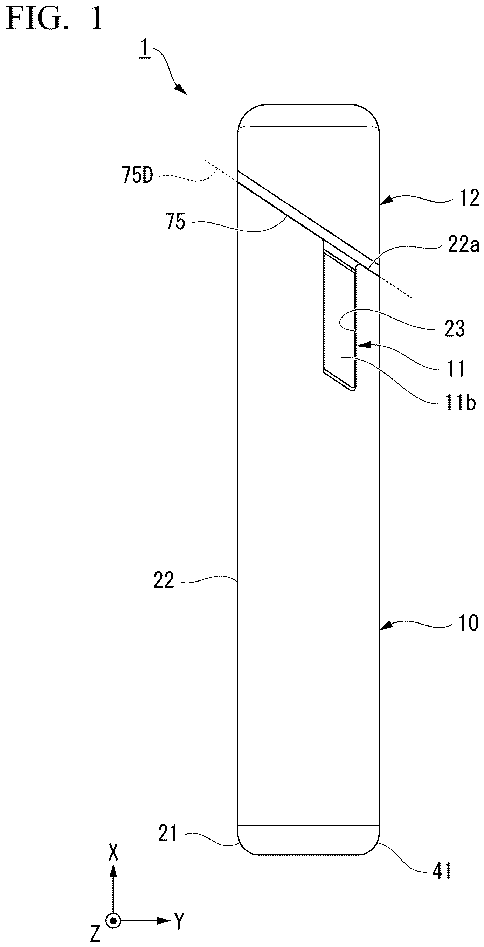

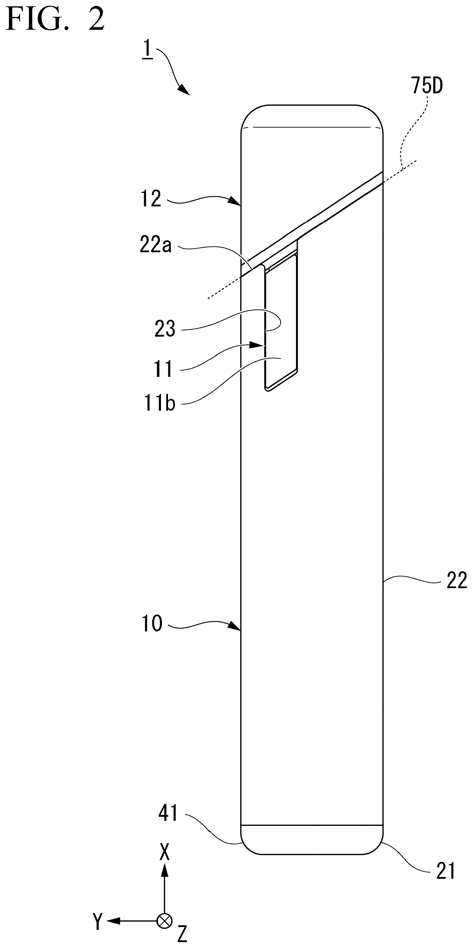

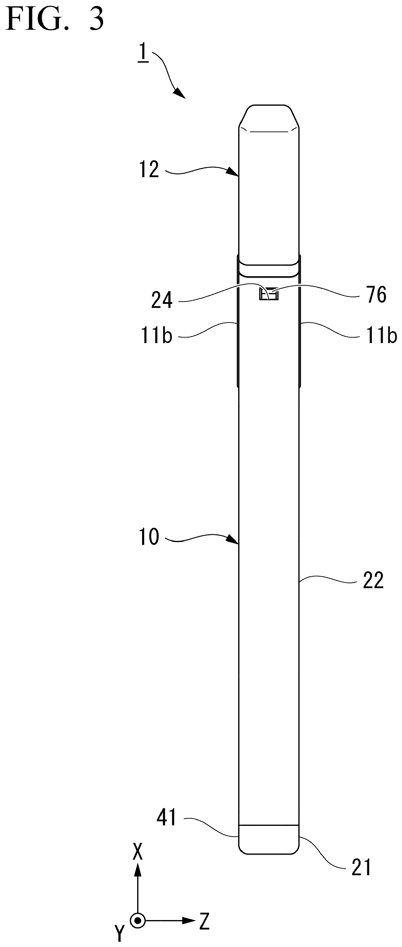

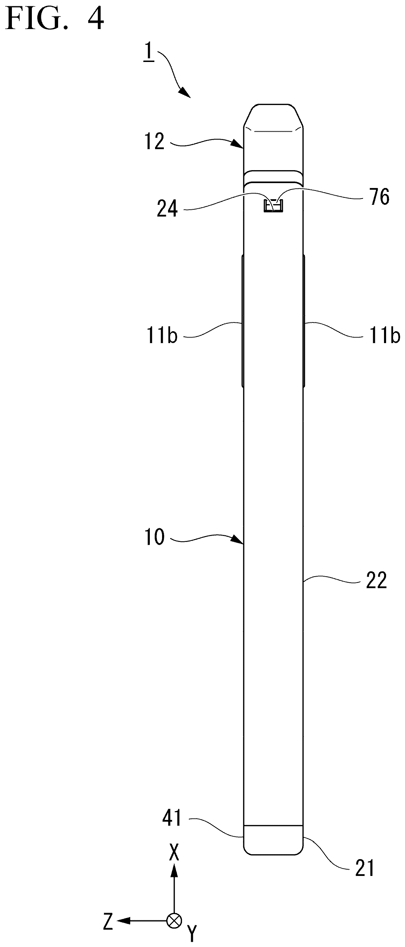

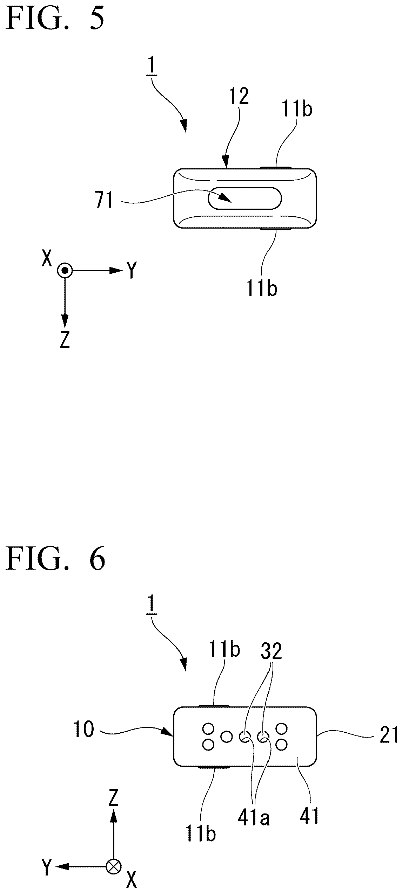

Fig. 1 is a front view of an aspirator according to the embodiment. Fig. 2 is a rear view of the aspirator according to the embodiment. Fig. 3 is a right side view of the aspirator according to the embodiment. Fig. 4 is a left side view of the aspirator according to the embodiment. Fig. 5 is a plan view of the aspirator according to the embodiment. Fig. 6 is a bottom view of the aspirator according to the embodiment.

An aspirator 1 is a so-called non-combustion-type aspirator, which is a device for obtaining an aroma by aspirating aerosol that has been atomized through heating via an aroma source.

As illustrated in Fig. 1, the aspirator 1 includes a main body unit 10, a cartridge 11 (which will also be referred to as an atomization unit), and an aroma source container 12. The cartridge 11 and the aroma source container 12 are mounted in the main body unit 10 in an attachable/detachable manner. The main body unit 10 (which will also be referred to as the aspirator 1 or a continuous body) in which the cartridge 11 and the aroma source container 12 are mounted is formed to have substantially a rectangular parallelepiped shape.

In the following description, an XYZ orthogonal coordinate system is set, and position relationships between the members may be described with reference to the XYZ orthogonal coordinate system. An X axis direction is a longitudinal direction of the aspirator 1, a Y axis direction is a width direction of the aspirator 1, and a Z axis direction is a thickness direction of the aspirator 1. In the following description, "direction" includes a direction toward both sides. When one side in "a direction" is indicated, it will be described as "a side direction".

### <Main body unit>

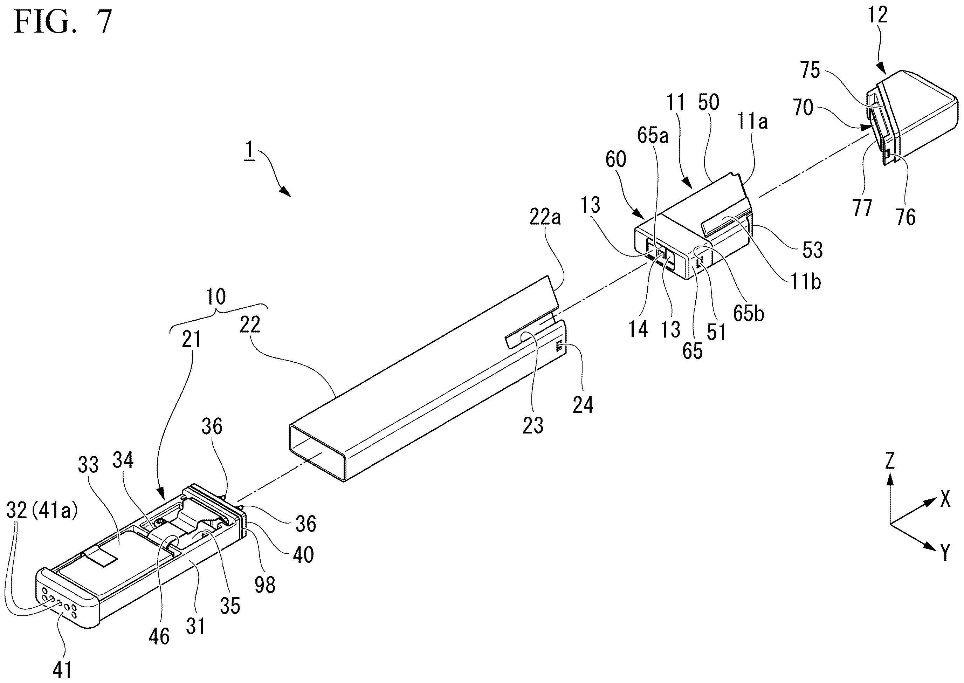

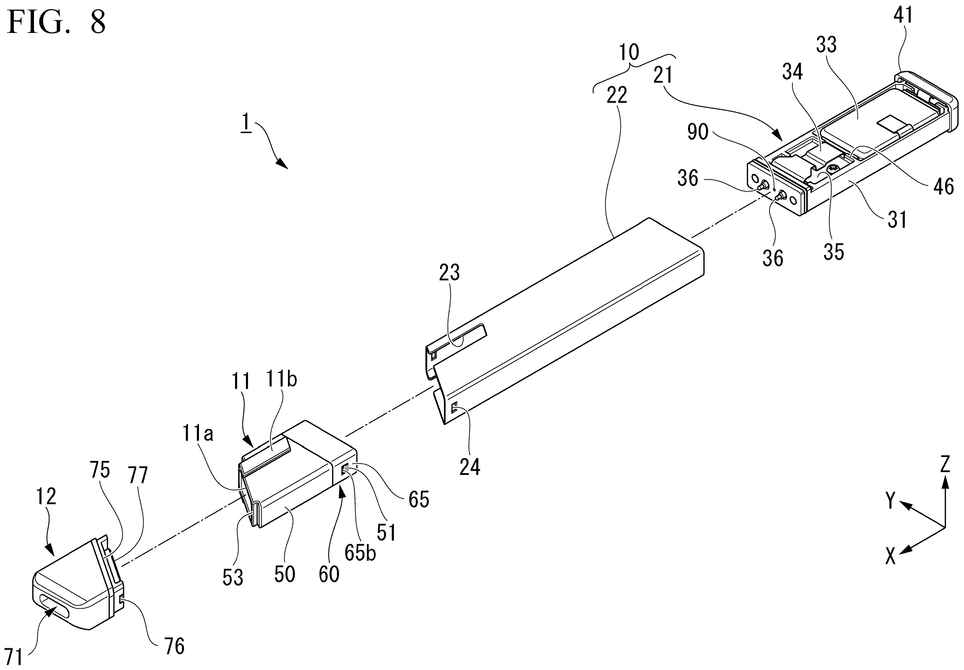

Fig. 7 is an exploded perspective view of the aspirator according to the embodiment viewed from a bottom surface side. Fig. 8 is an exploded perspective view of the aspirator according to the embodiment viewed from a flat surface side.

As illustrated in these diagrams, the main body unit 10 includes a power source unit 21 and a holding unit 22 (an accommodation portion). The holding unit 22 is formed to have a tubular shape extending in the X axis direction. The holding unit 22 is configured to be capable of accommodating the cartridge 11 from a first end portion side of the holding unit 22 (from a positive X side end of the holding unit 22) in the longitudinal direction. The holding unit 22 is configured such that the aroma source container 12 is capable of being mounted on the first end portion side of the holding unit 22 (the positive X side end of the holding unit) in the longitudinal direction.

The power source unit 21 includes a housing 31. The housing 31 is configured to be accommodated in the holding unit 22 inserted from a second end portion side of the holding unit 22 (a negative X side end of the holding unit 22) in the longitudinal direction. The holding unit 22 of the present embodiment is an outer housing that accommodates the housing 31 of the power source unit 21. The holding unit 22 may be a part of the housing 31 of the power source unit 21. Namely, the housing 31 of the power source unit 21 and the holding unit 22 may be integrated.

### <Power source unit>

The power source unit 21 includes the housing 31, a charging terminal 32, a battery 33, a flexible printed board 34, a rigid substrate 35 (a substrate), pin electrodes 36, and the like. The housing 31 is formed to have substantially a bottomed box shape extending in the X axis direction and opens at a positive Z side thereof. A pair of pin electrodes 36 are supported by an end wall 40 on the first end side of the housing 31 (the positive X side end of the housing) in the longitudinal direction. The pair of pin electrodes 36 extend in a manner of being parallel to the longitudinal direction (the X axis direction) of the housing 31 with an interval therebetween in the width direction (the Y axis direction) of the housing 31.

The charging terminal 32 is disposed on the second end portion side of the housing 31 (the negative X side end of the housing) in the longitudinal direction. A bottom portion cover 41 is attached to the second end portion of the housing 31 in the longitudinal direction, and a plurality of penetration ports 41a penetrating the housing 31 in the longitudinal direction are formed in the bottom portion cover 41. The charging terminal 32 is configured to be capable of being connected to an external charger (for example, a pocket charger) via the plurality of penetration ports 41a. A constitution in which electric power can be directly supplied from an external power source may be employed by using a universal serial bus (USB) connector or the like in the charging terminal 32.

A partition wall 46 dividing an internal space of the housing 31 between the end wall 40 and the bottom portion cover 41 described above is formed in the housing 31. The rigid substrate 35, the pin electrodes 36, and the like are disposed in the internal space of the housing 31 from the partition wall 46 on the positive X side end. The charging terminal 32, the battery 33, and the like are disposed in the internal space of the housing 31 from the partition wall 46 on the negative X side end. The flexible printed board 34 goes over the partition wall 46, extends from the first end portion side (the positive X side end) to the second end portion side (the negative X direction side end) of the housing 31 in the longitudinal direction, and is electrically connected to each of the components.

### <Holding unit>

The holding unit 22 is formed to have a square tube shape in a plan view or a bottom view. An inclined opening end 22a inclining with respect to the longitudinal direction (the X axis direction) of the holding unit 22 is formed on the first end portion side (the positive X side end portion) of the holding unit 22 in the longitudinal direction. The inclined opening end 22a inclines by substantially 45 degrees around a Z axis with respect to a Y-Z plane. An end portion of the inclined opening end 22a on a negative Y side end portion is positioned on the first end portion side (the positive X side end portion) of the holding unit 22 in the longitudinal direction compared to an end portion of the inclined opening end 22a on a positive Y direction side.

A cutout portion 23 for guiding to attach and detach the cartridge 11 is formed on the inclined opening end 22a at the positive Y direction side. The cutout portion 23 is formed on each of a front surface (refer to Fig. 1 or 7) and a rear surface (refer to Fig. 2 or 8) of the holding unit 22 and linearly extends from the inclined opening end 22a toward the second end portion side (in the negative X side direction) of the holding unit 22 in the longitudinal direction with a uniform width. An end portion of the cutout portion 23 on the negative X side extends in an oblique direction in a manner similar to that of the inclined opening end 22a.

Penetration ports 24 allowing the aroma source container 12 to be mounted are formed in the vicinity of the inclined opening end 22a. The penetration ports 24 are rectangular penetration ports formed on a right side surface (refer to Fig. 3 or 7) and a left side surface (refer to Fig. 4 or 8) of the holding unit 22. The penetration port 24 formed on the right side surface of the holding unit 22 is formed in a manner of being separated from the end portion of the inclined opening end 22a on the positive Y side to the negative X side by a certain distance. Similarly, the penetration port 24 formed on the left side surface of the holding unit 22 is also formed in a manner of being separated from the end portion of the inclined opening end 22a on the negative Y side to the negative X side by a certain distance.

### <Cartridge>

The cartridge 11 stores a liquid aerosol source and atomizes the liquid aerosol source. The cartridge 11 is accommodated inside the holding unit 22 from the inclined opening end 22a described above.

The cartridge 11 is formed to have a square column shape in a plan view or a bottom view. An inclined surface 11a inclining with respect to the longitudinal direction (the X axis direction) of the cartridge 11 is formed on the first end portion side (the positive X side) of the cartridge 11 in the longitudinal direction. The inclined surface 11a inclines in an oblique direction in a manner similar to that of the inclined opening end 22a of the holding unit 22 described above.

A guide portion 11b is formed in the cartridge 11. The guide portion 11b is a protruding portion which is guided to the cutout portion 23 described above in an attachment/detachment direction (the X axis direction) when the cartridge 11 is attached to and detached from the holding unit 22. The guide portion 11b is formed on the front surface (refer to Fig. 1 or 7) and the rear surface (refer to Fig. 2 or 8) of the cartridge 11 and linearly extends from the inclined surface 11a toward the second end portion side (the negative X side) of the cartridge 11 in the longitudinal direction with a uniform width.

An end portion of the guide portion 11b on the negative X side extends in an oblique direction in a manner similar to that of the inclined opening end 22a. An end portion of the guide portion 11b on the positive X side also extends in an oblique direction in a manner similar to that of the inclined opening end 22a. Namely, the guide portion 11b is formed to have a parallelogram shape in a front view or a rear view. Similarly, the cutout portion 23 is also formed to have a parallelogram shape in a front view or a rear view. However, as illustrated in Fig. 1, a dimension of the cutout portion 23 in the longitudinal direction (the X axis direction) is longer than a dimension of the guide portion 11b in the longitudinal direction (the X axis direction). Namely, the guide portion 11b is constituted to be able to slightly move in the X axis direction inside the cutout portion 23.

As illustrated in Fig. 7, plane electrodes 13 are exposed on an end surface of the cartridge 11 on the second end portion side (the negative X side) in the longitudinal direction. A pair of plane electrodes 13 are provided with an interval therebetween in the width direction (the Y axis direction) of the cartridge 11. The plane electrodes 13 are provided to be able to come into contact with the pair of pin electrodes 36 of the power source unit 21 in the X axis direction. An air intake port 14 is formed between the pair of plane electrodes 13. Air that has been taken in through the air intake port 14 passes through the inside of the cartridge 11 in the longitudinal direction (the X axis direction).

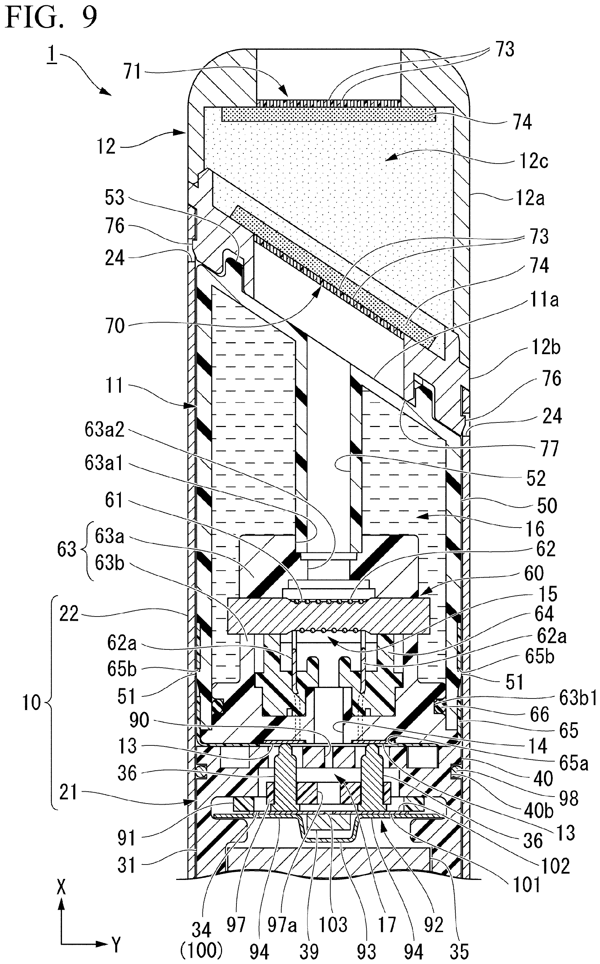

Fig. 9 is a cross-sectional constitution diagram of the aspirator according to the embodiment.

As illustrated in Fig. 9, the cartridge 11 includes a tank 50 and a heater unit 60. The tank 50 stores an aerosol source. The heater unit 60 atomizes the aerosol source. The tank 50 forms a part excluding a bottom portion of the cartridge 11 and is formed to have a square column shape in a plan view or a bottom view. The inclined surface 11a described above is formed on the first end portion side (the positive X side) of the tank 50 in the longitudinal direction. The guide portion 11b described above is formed on the front surface and the rear surface of the tank 50.

Engagement claws 51 are formed on the second end portion side (the negative X side) of the tank 50 in the longitudinal direction. A pair of engagement claws 51 are formed on the right side surface and the left side surface of the tank 50. The engagement claws 51 are provided to fix the heater unit 60 to the tank 50. A flow channel tube 52 is formed in the tank 50. The flow channel tube 52 penetrates the inclined surface 11a described above in the longitudinal direction (the X axis direction) of the tank 50. The flow channel tube 52 communicates with the air intake port 14 described above and serves as a flow channel for atomized aerosol.

An annular wall 53 is formed around an opening end of the flow channel tube 52 on the inclined surface 11a. The annular wall 53 is formed from the inclined surface 11a toward the first end portion side (the positive X side) of the tank 50 in the longitudinal direction with a uniform height. Namely, an upper end surface of the annular wall 53 extends in an oblique direction in a manner similar to that of the inclined surface 11a (the inclined opening end 22a).

The second end portion side (the negative X side) of the tank 50 in the longitudinal direction is opened. The heater unit 60 is attached to the tank 50 so as to block an opening of the tank 50 on the second end side (the negative X side). The heater unit 60 includes a wick 61, a heating wire 62, a support unit 63, a heater holder 64, and a heater cover 65. The wick 61 absorbs an aerosol source. The heating wire 62 heats the wick 61. The support unit 63 supports the wick 61. The heater holder 64 is accommodated inside the support unit 63. The heater cover 65 is engaged with the engagement claws 51 of the tank 50 described above.

The wick 61 is a liquid-absorptive member having substantially a columnar shape. The wick 61 is formed using a fiber body in which fibers are bundled, a porous body, or the like. The wick 61 linearly extends in the width direction (the Y axis direction) of the cartridge 11. Both end portions of the wick 61 are supported by the support unit 63. Both the end portions of the wick 61 extend outward in the width direction beyond a support position by the support unit 63. An aerosol source stored in the tank 50 is absorbed from both the end portions of the wick 61 due to capillarity or the like.

The heating wire 62 is wound in a spiral shape such that a periphery of the wick 61 is surrounded. In the heating wire 62, at least a part thereof need only come into contact with the wick 61. A pair of terminal portions 62a of the heating wire 62 extend to the second end portion side (the negative X side) of the cartridge 11 in the longitudinal direction. The pair of terminal portions 62a are electrically connected to the pair of plane electrodes 13 described above, respectively. When the heating wire 62 is electrified via the pair of plane electrodes 13, the wick 61 is heated. When the wick 61 is heated, the aerosol source absorbed by the wick 61 is atomized.

The support unit 63 includes a first support body 63a and a second support body 63b. Both the end portions of the wick 61 are sandwiched between the first support body 63a and the second support body 63b. The second support body 63b is formed to have a bottomed square tube shape. An atomization chamber 15 atomizing an aerosol source is formed inside the second support body 63b. The first support body 63a is formed to have a topped square tube shape. The first support body 63a blocks a top portion of the atomization chamber 15. Both the end portions of the wick 61 are sandwiched between contact surfaces of the first support body 63a and the second support body 63b.

A fitting groove 63a1 and a penetration port 63a2 are formed in a top wall of the first support body 63a. The fitting groove 63a1 is fitted into the flow channel tube 52 of the tank 50 described above. The penetration hole 63a2 communicates with the fitting groove 63a1. The air intake port 14 described above is formed in a bottom wall of the second support body 63b. The air intake port 14 communicates with the atomization chamber 15. Namely, air that has been taken in through the air intake port 14 passes the atomization chamber 15, the penetration port 63a2, the fitting groove 63a1, and the flow channel tube 52 and goes out in the longitudinal direction of the cartridge 11.

The heater holder 64 is accommodated in the atomization chamber 15. The heater holder 64 holds the pair of terminal portions 62a of the heating wire 62. An annular groove 63b 1 is formed in a peripheral wall of the second support body 63b. An annular seal member 66 is disposed in the annular groove 63b1. A seal member 66 liquid-tightly seals a gap between the peripheral wall of the second support body 63b and an inner wall of the tank 50. Since the support unit 63 is liquid-tightly fitted into the inner wall of the tank 50, a liquid accommodation chamber 16 storing an aerosol source is formed outside the support unit 63.

The heater cover 65 is formed to have a bottomed square tube shape supporting the support unit 63 described above. An opening portion 65a for exposing the pair of plane electrodes 13 and the air intake port 14 described above is formed in a bottom wall of the heater cover 65. An engagement port 65b with which the engagement claws 51 of the tank 50 described above engage is formed in a peripheral wall of the heater cover 65. When the engagement claws 51 engage with the engagement port 65b, the tank 50 and the heater unit 60 are integrated.

### <Aroma source container>

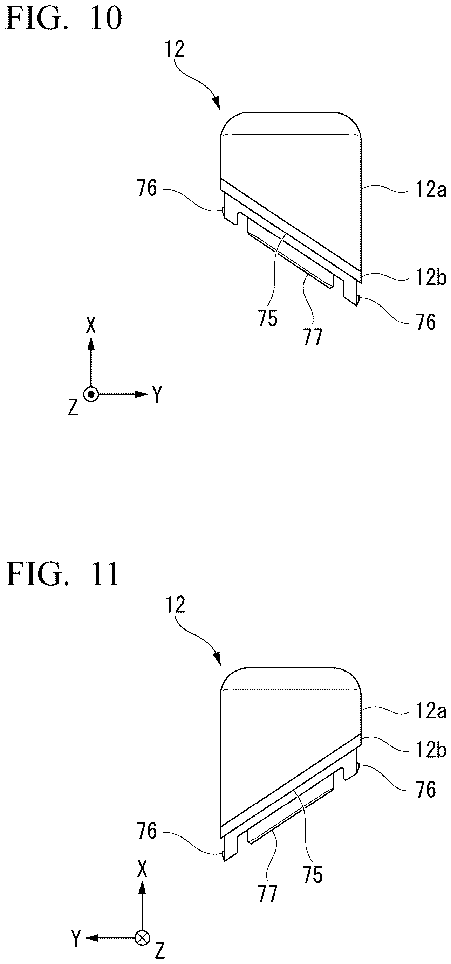

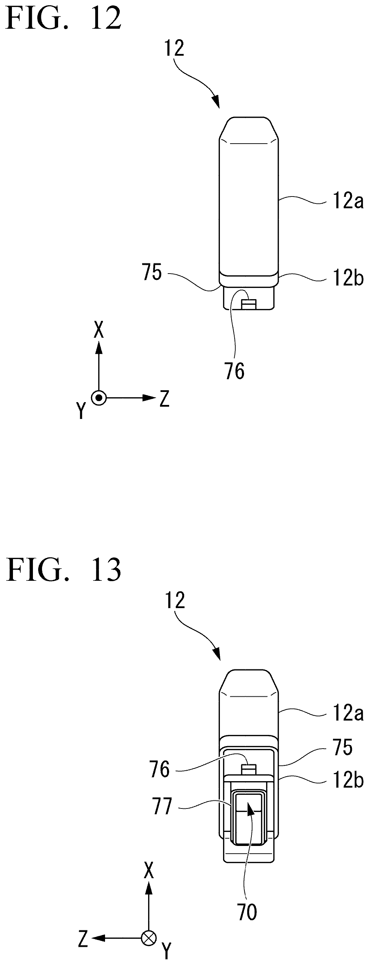

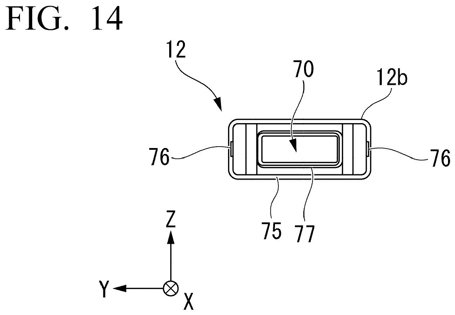

Fig. 10 is a front view of an aroma source container according to the embodiment. Fig. 11 is a rear view of the aroma source container according to the embodiment. Fig. 12 is a right side view of the aroma source container according to the embodiment. Fig. 13 is a left side view of the aroma source container according to the embodiment. Fig. 14 is a bottom view of the aroma source container according to the embodiment.

The aroma source container 12 accommodates an aroma source, and an aroma is added to aerosol that has been atomized in the cartridge 11. Cut tobacco or a compact formed of granular tobacco raw materials can be used as a raw material piece constituting an aroma source. An aroma source may be constituted of a plant other than tobacco (for example, mint, traditional Chinese medicine, or herb). A flavor such as menthol may be applied to an aroma source. The aroma source container 12 is mounted at the inclined opening end 22a of the holding unit 22 described above (refer to Figs. 1 and 7).

As illustrated in Fig. 9, an inflow port 70 and an aspiratory port 71 are formed in the aroma source container 12. Aerosol generated by the cartridge 11 flows into the inflow port 70. Aerosol to which an aroma is applied by an aroma source is aspirated and flows out through the aspiratory port 71. The inflow port 70 inclines in an oblique direction in a manner similar to that of the inclined opening end 22a of the holding unit 22 described above. Namely, the inflow port 70 is formed to face the aspiratory port 71 in an oblique direction. In other words, the inflow port 70 is formed such that at least a part thereof includes a region in which an inflow direction (the X axis direction) of aerosol extends at an angle with respect to a perpendicular surface (a Y-Z plane).

An aroma source accommodation chamber 12c is formed inside the aroma source container 12, the aroma source accommodation chamber 12c communicates with the inflow port 70 and the aspiratory port 71. The aroma source described above is accommodated in the aroma source accommodation chamber 12c. The aroma source accommodation chamber 12c is formed by fitting a first member 12a with a second member 12b such that a part of the second member is inlaid with an inward of the first member 12a. The first member 12a forms the inflow port 70. The second member 12b forms the aspiratory port 71. A plurality of mesh openings 73 are formed in the inflow port 70 and the aspiratory port 71. A filter 74 is provided on an inward side of the plurality of mesh openings 73 (the aroma source accommodation chamber 12c side). For example, the filter 74 is formed of non-woven fabric. A constitution in which the filter 74 plays a role of the mesh openings 73 and the filter 74 and the mesh openings 73 are integrated may be employed.

An abutment portion 75 (refer to Figs. 1 and 10) abutting the inclined opening end 22a of the holding unit 22 is formed on the inflow port 70 side (the negative X side) of the aroma source container 12. A dividing line 75D in an oblique direction with respect to the longitudinal direction of the holding unit 22 is formed between the aroma source container 12 and the holding unit 22 in a state in which the abutment portion 75 and the inclined opening end 22a abut each other.

Fixing claws 76 (refer to Figs. 9 and 10) are formed on the inflow port 70 side (the negative X side) of the aroma source container 12. A pair of fixing claws 76 are formed in a manner corresponding to the penetration ports 24 of the holding unit 22 described above, and they respectively engage with the penetration ports 24 so that the aroma source container 12 is fixed to the holding unit 22. A guide wall 77 is formed on the inflow port 70 side (the negative X side) of the aroma source container 12.

The guide wall 77 is installed between the pair of fixing claws 76. The guide wall 77 hangs in the negative X side direction from the inflow port 70 of the aroma source container 12 with a certain length. A lower end surface of the guide wall 77 extends in an oblique direction in a manner similar to that of the abutment portion 75 (the inclined opening end 22a). As illustrated in Figs. 9 and 14, the guide wall 77 is formed around the inflow port 70. As illustrated in Fig. 9, the guide wall 77 inserted into the inward side of the annular wall 53 of the cartridge 11 described above and performs positioning of the aroma source container 12 with respect to the holding unit 22.

### <Assembly of power source unit>

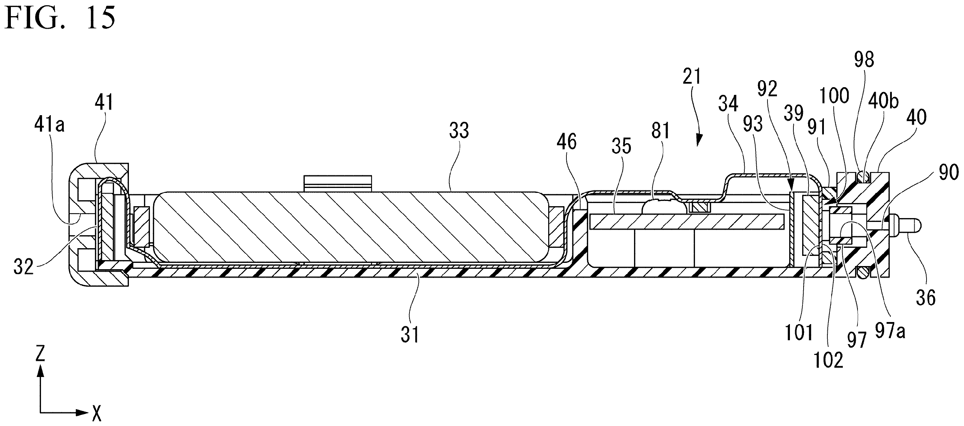

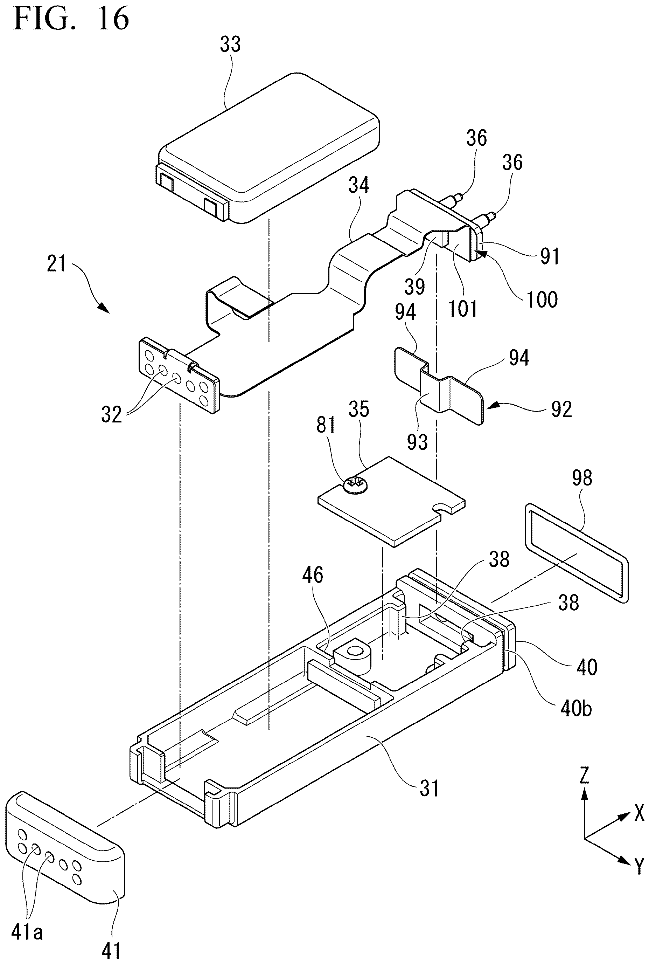

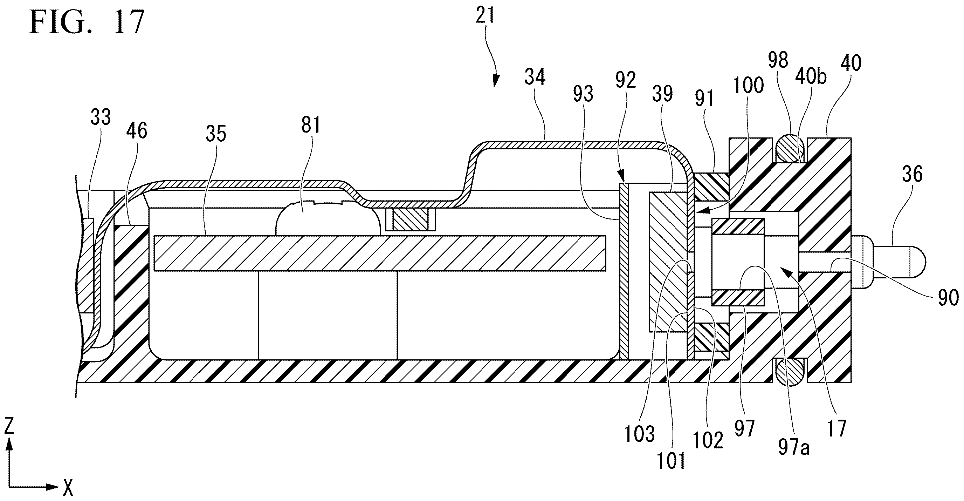

Fig. 15 is a longitudinal cross-sectional view of a power source unit according to the embodiment. Fig. 16 is an exploded perspective view of the power source unit according to the embodiment. Fig. 17 is a longitudinal cross-sectional view of the first end portion side of the power source unit according to the embodiment in the longitudinal direction.

As illustrated in Fig. 16, many components including the battery 33, the flexible printed board 34, the rigid substrate 35, and the like described above are assembled in the housing 31 of the power source unit 21.

The battery 33 is formed to have substantially a rectangular parallelepiped shape having the X axis direction as the longitudinal direction. The battery 33 is accommodated on the second end portion side (the negative X side) of the housing 31 in the longitudinal direction from the partition wall 46 described above inside the housing 31. A power source portion (the battery 33) to be mounted in the aspirator 1 is not limited to a secondary battery and may be a super capacitor or the like as a power source which can be charged and discharged. The power source portion may be a primary battery.

The rigid substrate 35 is accommodated inside the housing 31 on the first end portion side (the positive X side) of the housing 31 in the longitudinal direction from the partition wall 46 described above. Front and rear surfaces of the rigid substrate 35 are disposed in a manner of intersecting the thickness direction (the Z axis direction) of the housing 31. Many electronic components (not illustrated) are mounted on the front and rear surfaces of the rigid substrate 35. The rigid substrate 35 is fixed to the housing 31 by using a screw 81 screwed in the thickness direction thereof. The rigid substrate 35 may be a flexible printed board similar to the flexible printed board 34.

As illustrated in Fig. 15, the flexible printed board 34 extends from the first end portion side (the positive X side) to the second end portion side (the negative X side) of the housing 31 in the longitudinal direction. Specifically, the flexible printed board 34 passes the positive Z side of the rigid substrate 35, goes over the partition wall 46, passes a negative Z side of the battery 33, and extends to a rear surface region of the bottom portion cover 41 described above.

The flexible printed board 34 has a perpendicular disposition portion 100. The perpendicular disposition portion 100 is disposed on the first end portion side (the positive X side) of the housing 31 in the longitudinal direction so as to be substantially perpendicular to the longitudinal direction (the X axis direction) of the housing 31 (substantially a Y-Z plane). The expression "substantially perpendicular" ideally denotes a perpendicular state at 90 degrees with respect to the X axis direction or a state parallel to a Y-Z plane (zero degrees), but it is not realistic because the flexible printed board 34 is flexible. Therefore, here, for example, regarding the expression "substantially perpendicular", a state of being perpendicular to the X axis direction at 75 degrees to 105 degrees or a state within a range of ±15 degrees around the Y axis and the Z axis with respect to a Y-Z plane will be regarded as a state of being "substantially perpendicular".

A sensor 39 is mounted in the perpendicular disposition portion 100. The sensor 39 of the present embodiment is a pressure sensor having substantially a rectangular parallelepiped shape. The sensor 39 is disposed such that a short side direction in which the dimension is the shortest extends in the longitudinal direction (the X axis direction) of the housing 31 among three-axis orthogonal directions of the rectangular parallelepiped of the sensor 39. The sensor 39 is not limited to a pressure sensor and may be a temperature sensor or the like.

In the perpendicular disposition portion 100, the pin electrodes 36 described above are mounted on a second face 102 on a side opposite to a first face 101 on which the sensor 39 is mounted. The pin electrodes 36 are supported by the end wall 40 on the first end portion side (the positive X side) of the housing 31 in the longitudinal direction. A ventilation port 90 penetrating the housing 31 in the longitudinal direction is formed in the end wall 40. The ventilation port 90 is disposed between the pair of pin electrodes 36. An annular groove 40b is formed in an outer circumference of the end wall 40. An annular seal member 98 press-welded to an inner wall surface of the holding unit 22 is disposed in the annular groove 40b. For example, a seal member 98 is preferably an elastic body such as a silicon ring.

As illustrated in Fig. 17, a frame member 91 having a rectangular frame shape is disposed in a gap between the end wall 40 and the perpendicular disposition portion 100. The frame member 91 forms a pressure variation chamber 17 between the end wall 40 and the perpendicular disposition portion 100. The pressure variation chamber 17 communicates with the ventilation port 90. The frame member 91 is fixed to the perpendicular disposition portion 100 side. A reinforcing member 97 connecting the pair of pin electrodes 36 to each other is installed inside the pressure variation chamber 17. A penetration port 97a for forming a communication space leading to the sensor 39 is formed in the reinforcing member 97 at a position facing the ventilation port 90 in the longitudinal direction of the housing 31.

A connection port 103 penetrating the housing 31 in the longitudinal direction (the X axis direction) and spatially connecting the pressure variation chamber 17 and the sensor 39 to each other is formed in the perpendicular disposition portion 100. Namely, the connection port 103 allows the first face 101 and the second face 102 of the perpendicular disposition portion 100 to spatially communicate with each other. The sensor 39 is attached to the first face 101 so as to block the connection port 103. A side of the sensor 39 facing the connection port 103 constitutes a pressure detection portion (a detection surface). For example, an electrostatic capacitance-type pressure sensor can be employed as the sensor 39. That is, the sensor 39 detects a behavior of a diaphragm (the detection portion) which is deformed in accordance with pressure variation as a change in the electrostatic capacitance.

As illustrated in Fig. 16, a support member 92 is disposed on the first face 101 side of the perpendicular disposition portion 100. The support member 92 includes a recessed portion 93 which is formed to have substantially a U-shape when viewed in the thickness direction (the Z axis direction) of the housing 31, and support portions 94 which are provided on both sides of the recessed portion 93 and support at least a part of rear surface regions of the pin electrodes 36. The recessed portion 93 surrounds a periphery of the sensor 39 but it may be in a non-contact state with the sensor 39. A space surrounding the sensor 39 may be formed by sealing the positive Z side (the flexible substrate 34 side) of the recessed portion 93 with a resin or the like. In contrast, the support portions 94 come into contact with the first face 101 of the perpendicular disposition portion 100 and receive pushing reaction forces of the pin electrodes 36. Here, pushing reaction forces of the pin electrodes 36 indicate forces received when the pin electrodes 36 come into contact with the plane electrodes 14 of the cartridge 11. Namely, the pin electrodes 36 are biased to the cartridge 11 side (the positive X side) by springs (not illustrated) and are elastically displaced to the negative X side when they come into contact with the cartridge 11. An energy is accumulated in the springs due to elastic displacement to the negative X side, and a reaction force is generated on the negative X side.

That is, since the perpendicular disposition portion 100 is flexible, it is necessary to have the support member 92 (a strength member) for receiving pushing reaction forces of the pin electrodes 36. For example, the support member 92 can be formed by bending a stainless steel plate or the like. An attachment wall 38 for attaching the support member 92 is formed in the housing 31. The attachment wall 38 is disposed on the first end portion side of the housing 31 in the longitudinal direction from the rigid substrate 35 and is provided in a manner of protruding from the inner wall surfaces of the left and right peripheral walls of the housing 31 in the Y axis direction.

The "rear surface regions of the pin electrodes 36" denotes regions on the first surface 101 side and overlapping the external shapes of the pin electrodes 36 when viewed in the longitudinal direction (the X axis direction) of the housing 31. Therefore, the support portions 94 supporting at least a part of the rear surface regions of the pin electrodes 36 are disposed in a manner of overlapping at least a part of the external shapes of the pin electrodes 36 when viewed in the longitudinal direction (the X axis direction) of the housing 31 and the support portions 94 come into contact with at least a part of regions on the first face 101 side overlapping the external shapes of the pin electrodes 36.

As described above, the flexible printed board 34 extends from the first end portion side of the longitudinal direction to the second end portion side of the housing 31. The battery 33, the sensor 39, the charging terminal 32, and the rigid substrate 35 described above are electrically connected to the flexible printed board 34. Namely, the flexible printed board 34 plays a role of a wiring for connecting the components to each other. For this reason, there is no need to wire many conductor lines inside the housing 31. Connection between the flexible printed board 34 and each of the components may be connection using male-female connectors or soldering.

### <Method of assembling aspirator>

Next, a method of assembling the aspirator 1 described above will be described.

As illustrated in Fig. 7, regarding assembling of the aspirator 1 of the present embodiment, first, the holding unit 22 is assembled in the power source unit 21. Specifically, the housing 31 of the power source unit 21 is thrust into the holding unit 22 from the second end portion side (the negative X side) of the holding unit 22 in the longitudinal direction. Consequently, a peripheral surface of the housing 31 is fitted into the inner wall surface of the holding unit 22, and the seal member 98 described above is sandwiched between the peripheral surface of the housing 31 and the inner wall surface of the holding unit 22. Therefore, the power source unit 21 and the holding unit 22 are assembled together. When the power source unit 21 and the holding unit 22 are detached, a reversed operation of the operation described above is performed.

Subsequently, the cartridge 11 is inserted into the holding unit 22. Specifically, the cartridge 11 is inserted into the holding unit 22 from the first end portion side (the positive X side) of the holding unit 22 in the longitudinal direction in a state in which the plane electrodes 13 of the cartridge 11 face the second end portion side (the negative X side) of the holding unit 22 in the longitudinal direction. The cutout portion 23 is formed on the first end portion side (the positive X side) of the holding unit 22 in the longitudinal direction. The cartridge 11 is smoothly inserted into the holding unit 22 by fitting the guide portion 11b of the cartridge 11 into the cutout portion 23. Accordingly, the cartridge 11 is assembled in the power source unit 21 in a regular posture. Namely, reverse insertion of the cartridge 11 can be prevented.

When the cartridge 11 is inserted into the holding unit 22, as illustrated in Fig. 9, the pin electrodes 36 of the power source unit 21 are connected to the plane electrodes 13 of the cartridge 11. Accordingly, the heating wire 62 of the heater unit 60 can be electrified with electric power of the power source unit 21 via the pin electrodes 36 and the plane electrodes 13. When the cartridge 11 is detached from the holding unit 22, a reversed operation of the operation described above is performed. However, as illustrated in Fig. 7, since the guide portion 11b (the protruding portion) is formed in the cartridge 11, the cartridge 11 is slidable by catching the guide portion with a figure. Therefore, the cartridge 11 can be smoothly detached from the holding unit 22.

Next, the aroma source container 12 is assembled in the holding unit 22. Specifically, the fixing claws 76 of the aroma source container 12 are interlocked in the penetration ports 24 of the holding unit 22. Consequently, the guide wall 77 of the aroma source container 12 is inserted into the inward side of the annular wall 53 of the cartridge 11 and comes into contact with the inclined surface 11a. Accordingly, the aroma source container 12 is in a state of pressing the cartridge 11 to the power source unit 21 side. Accordingly, the pin electrodes 36 of the power source unit 21 are elastically displaced to the negative X side with an energy accumulated therein and come into tight contact with the plane electrodes 13 of the cartridge 11.

With this, assembling of the aspirator 1 is completed.

### <Method of using aspirator>

When the aspirator 1 described above is used, a user aspirates the aroma source container 12 or a mouthpiece or the like (not illustrated) which can be attached to the aroma source container 12 in a state of holding it in the mouth. Consequently, air inside the pressure variation chamber 17 is also aspirated through the ventilation port 90, and the pressure inside the pressure variation chamber 17 becomes a negative pressure. The sensor 39 (the pressure sensor) is spatially connected to the pressure variation chamber 17 via the connection port 103 and outputs a start signal toward a control unit, for example, when the pressure inside the pressure variation chamber 17 becomes lower than a predetermined value is detected.

The control unit which has received a start signal generates heat by means of electrification of the heating wire 62 of the cartridge 11. The pressure inside the holding unit 22 also becomes a negative pressure so that new air is introduced into the holding unit 22 from the outside. For example, air introduced from the outside passes a gap between the holding unit 22 and the cartridge 11 via the penetration ports 24 formed in the holding unit 22 and is guided to the air intake port 14 of the cartridge 11. Alternatively, air may be introduced into the holding unit 22 via a gap between the cutout portion 23 and the guide portion 11b. A dedicated outside air introducing port may be formed in the holding unit 22.

The wick 61 is heated when the heating wire 62 is electrified. Consequently, a liquid aerosol source with which the wick 61 has been impregnated is atomized. The atomization chamber 15 is filled with atomized aerosol. Thereby, atomized aerosol is sucked up to the aroma source container 12 side through the flow channel tube 52 of the tank 50 together with new air that has been introduced into the atomization chamber 15 via the air intake port 14. Thereafter, mixed gas of atomized aerosol and air enters the inside of the mouth of a user through the aroma source container 12. Accordingly, a user can obtain a smoke and an aroma.

### [Operational effects]

As illustrated in Fig. 15, the power source unit 21 of the present embodiment described above includes the battery 33, the flexible printed board 34 that is electrically connected to the battery 33, the sensor 39 that is mounted on the flexible printed board 34, and the housing 31 that accommodates at least the battery 33, the flexible printed board 34, and the sensor 39. The flexible printed board 34 has the perpendicular disposition portion 100 which is disposed in a manner of being substantially perpendicular to the longitudinal direction of the housing 31. The sensor 39 is mounted in the perpendicular disposition portion 100.

According to this constitution, the flexible printed board 34 has the perpendicular disposition portion 100 which is disposed in a manner of being substantially perpendicular to the longitudinal direction (the X axis direction) of the housing 31 (substantially a Y-Z plane), and the sensor 39 is mounted in the perpendicular disposition portion 100. Therefore, a dimension of the housing 31 in the longitudinal direction can be shortened. Accordingly, not only miniaturization of the device but also space-saving inside the housing 31 and improvement of easiness in assembly of the components can be achieved.

In the present embodiment, in the perpendicular disposition portion 100, the pin electrodes 36 are mounted on the second face 102 on a side opposite to the first face 101 on which the sensor 39 is mounted.

According to this constitution, the pin electrodes 36 are mounted on a side opposite to the sensor 39 utilizing the perpendicular disposition portion 100. Therefore, both the components can be closely disposed, and thus miniaturization of the device can be better achieved.

In the present embodiment, the sensor 39 is a pressure sensor. The housing 31 has the end wall 40 supporting the pin electrodes 36. The ventilation port 90 penetrating the housing 31 in the longitudinal direction is formed in the end wall 40.

According to this constitution, since the distance between the pin electrodes 36 and the sensor 39 (the pressure sensor) is short, the ventilation port 90 is formed in the end wall 40 supporting the pin electrodes 36. Therefore, sensitivity of the sensor 39 can be improved.

In the present embodiment, the frame member 91 that forms the pressure variation chamber 17 communicating with the ventilation port 90 is provided in the gap between the end wall 40 and the perpendicular disposition portion 100.

According to this constitution, the pressure variation chamber 17 is formed in the gap between the end wall 40 and the perpendicular disposition portion 100 by the frame member 91. Therefore, the dimension of the pressure variation chamber 17 in the longitudinal direction of the housing 31 can be shortened, and thus miniaturization of the device can be better achieved.

In the present embodiment, the connection port 103 penetrating the housing 31 in the longitudinal direction and spatially connecting the pressure variation chamber 17 and the sensor 39 to each other is formed in the perpendicular disposition portion 100.

According to this constitution, since the connection port 103 penetrating the housing 31 in the longitudinal direction is formed in the perpendicular disposition portion 100, the pressure variation chamber 17 and the sensor 39 can be connected to each other over a short distance. Accordingly, the sensitivity of the sensor 39 can be improved.

In the present embodiment, includes the support member 92 supporting at least a part of the rear surface regions of the pin electrodes 36 is disposed on the first face 101 side of the perpendicular disposition portion 100.

According to this constitution, pushing reaction forces of the pin electrodes 36 can be received by the support member 92 supporting the rear surface region of the flexible perpendicular disposition portion 100. Accordingly, poor contact between the pin electrodes 36 and the plane electrodes 14 caused due to flexibility of the perpendicular disposition portion 100 can be curbed.

In the present embodiment, the power source unit 21 includes the charging terminal 32 for charging the battery 33, and the rigid substrate 35 that is accommodated in the housing 31. In the power source unit 21, the battery 33, the sensor 39, the charging terminal 32, and the rigid substrate 35 are electrically connected to the flexible printed board 34.

According to this constitution, the flexible printed board 34 plays a role of a wiring for connecting the components to each other. Therefore, there is no need to install many conductor lines inside the housing 31. Accordingly, space-saving inside the housing 31 and improvement of easiness in assembly of the components can be achieved.

In the present embodiment, the perpendicular disposition portion 100 is disposed on the first end portion side of the housing 31 in the longitudinal direction. The charging terminal 32 is disposed on the second end portion side of the housing 31 in the longitudinal direction. The flexible printed board 34 extends from the first end portion side of the longitudinal direction to the second end portion side of the housing 31 .

According to this constitution, the components can be connected to each other with one flexible printed board 34 from the first end portion side to the second end portion side of the housing 31 in the longitudinal direction.

The main body unit 10 of the present embodiment includes the power source unit 21 described above, and the accommodation portion (the holding unit 22) that is able to accommodate the cartridge 11 which is electrically connected to the power source unit 21.

According to this constitution, replacement of the cartridge 11, supplementation of an aerosol source, and the like can be easily performed by an operation of attaching and detaching the cartridge 11 with respect to the holding unit 22. Since the miniaturized power source unit 21 is provided, miniaturization of the device in its entirety can be achieved.

In the present embodiment, the accommodation portion is the holding unit 22 (the outer housing) accommodating the housing 31 of the power source unit 21.

According to this constitution, replacement of the cartridge 11, supplementation of an aerosol source, and the like are easily performed by an operation of attaching and detaching the cartridge 11 with respect to the holding unit 22 (the outer housing). The accommodation portion may be a part of the housing 31 of the power source unit 21.

The aspirator 1 of the present embodiment includes the main body unit 10 described above, and the cartridge 11 that is accommodated in the main body unit 10 and is electrically connected to the power source unit 21.

According to this constitution, since the miniaturized power source unit 21 is provided, miniaturization of the device (the aspirator 1) in its entirety can be achieved.

In the present embodiment, the aroma source container 12 that is mounted in the holding unit 22 is provided.

According to this constitution, an aroma can be added to aerosol passing through the aspiratory port 71.

### <Other modification examples>

Hereinabove, a preferable embodiment of the present invention has been described, but the present invention is not limited to the embodiment. Addition, omission, replacement, and other changes of the constitutions can be made within a range not departing from the gist of the present invention. The present invention is not limited by the foregoing description and is limited by only the accompanying claims.

For example, in the embodiment described above, as an example of an aerosol generation device generating aerosol without having combustion, an example of the aspirator 1 in which the aroma source container 12 is constituted in an attachable/detachable manner has been described. An aspirator is not limited to only this constitution. As another example of an aerosol generation device, a constitution having no aroma source container 12 as in electronic cigarettes (a constitution accommodating no aroma source and having only a mouthpiece) may be employed. In this case, an aerosol source including an aroma is accommodated inside the cartridge 11, and aerosol including the aroma is generated by the aerosol generation device.

That is, in the embodiment described above, a device including the main body unit 10 and the cartridge 11 without including the aroma source container 12 may be referred to as the aerosol generation device. A main body unit of the aerosol generation device may include only the main body unit 10 without including the aroma source container 12 and the cartridge 11.

In the embodiment described above, a case in which the main body unit 10 has a divided constitution of the power source unit 21 and the holding unit 22 has been described. The main body unit 10 is not limited to only this constitution. For example, the power source unit 21 and the holding unit 22 may be integrally formed. In this case, a constitution in which only the part of the battery 33 is not present in the housing 31 (a constitution in which the housing 31 is provided in only both end portions on the rigid substrate 35 side and the charging terminal 32 side) may be employed.

The holding unit 22 and the aroma source container 12 (or a mouthpiece) may be integrally formed. At least any one of the power source unit 21, the holding unit 22, and the aroma source container 12 (or a mouthpiece) may be able to be further divided into a plurality of units.

In the embodiment described above, a constitution in which the holding unit 22 is formed to have a tubular shape surrounding a periphery of the cartridge 11 has been described. The holding unit 22 is not limited to only this constitution. The holding unit 22 need only be constituted to be able to hold the cartridge 11. In this specification, attachment and detachment between the cartridge 11 and the main body unit 10 (the power source unit 21) is not limited to a constitution in which the cartridge 11 is accommodated inside the holding unit 22 and is held by the aroma source container 12 (or a mouthpiece) and also includes a constitution in which the pin electrodes 36 and the plane electrodes 13 simply perform connection and disconnection.

In the embodiment described above, a constitution in which the power source unit 21 and the holding unit 22 are formed to have tubular shapes in which they are coaxially disposed has been described. The power source unit 21 and the holding unit 22 are not limited to only this constitution. The power source unit 21 and the holding unit 22 may have shapes different from each other. Namely, the aspirator 1 is not limited to having substantially a rectangular parallelepiped shape described above. For example, the aspirator 1 may have a polygonal shape other than a square shape, a circular shape, an elliptical shape, or the like in a plan view or a bottom view.

In the embodiment described above, a constitution in which the cutout portion 23 and the guide portion 11b are provided on the front surface side and the rear surface side has been described. Even when the cutout portion 23 and the guide portion 11b are provided on only one of the front surface side or the rear surface side, the direction of the cartridge 11 can be determined, and the effect of guidance described above can also be exhibited. The cutout portion 23 and the guide portion 11b may not be formed to have a parallelogram shape in a front view or a rear view. Namely, for example, the cutout portion 23 and the guide portion 11b may be formed to have a rectangular shape in a front view or a rear view. The cutout portion 23 and the guide portion 11b need only be provided on both the front surface side and the rear surface side and be formed to have a parallelogram shape. For example, even if the cutout portion 23 is formed at a center position in the width direction (the Y axis direction) or one end portion side of the longitudinal direction of the cartridge 11 does not incline (for example, the cartridge 11 has a square column shape), one insertion direction can be determined for the cartridge 11. For this reason, an alternative choice of a user can be eliminated, and thus reliable electrical connection (connection to the pin electrodes 36) can be achieved.

In the embodiment described above, a constitution having no button for outputting a start preparation signal (a constitution in which the device is started in response to detection of a pressure sensor) has been described. However, a constitution having a button for outputting a start preparation signal (a constitution in which the device is started in response to a press of a button) may be employed.

In the embodiment described above, a constitution in which the components are connected to each other with one flexible printed board 34 has been described. A constitution in which at least any one of the battery 33, the sensor 39, the charging terminal 32, and the rigid substrate 35 is electrically connected to the flexible printed board 34 and the components which are not electrically connected to the flexible printed board 34 are electrically connected separately using conductor lines or the like may be employed.

A part or all of the embodiment described above may also be described as the following Appendix, but it is not limited thereto.

### (Appendix 1)

A power source unit of an aerosol generation device includes a power source portion, a sensor, and a housing that accommodates at least the power source portion and the sensor. The sensor is disposed in a manner of being substantially perpendicular to a longitudinal direction of the housing.

Further, the constituent elements in the embodiment described above can be suitably replaced with known constituent elements within a range not departing from the gist of the present invention, and each of the modification examples described above may be suitably combined.

### [Industrial Applicability]

It is possible to provide a power source unit of an aerosol generation device, a main body unit of an aerosol generation device, an aerosol generation device, and a non-combustion-type aspirator which have been miniaturized.

### [Reference Signs List]

1 Aspirator
2 Aspirator
10 Main body unit
11 Cartridge
11a Inclined surface
11b Guide portion
12 Capsule
12a First member
12b Second member
12c Aroma source accommodation chamber
13 Plane electrode
14 Air intake port
15 Atomization chamber
16 Liquid accommodation chamber
17 Pressure variation chamber
21 Power source unit
22 Holding unit
22a Inclined opening end
23 Cutout portion
24 Penetration port
31 Housing
32 Charging terminal
33 Battery
34 Flexible printed board
35 Rigid substrate
36 Pin electrode
38 Attachment wall
39 Sensor
40 End wall
40b Annular groove
41 Bottom portion cover
41a Penetration port
46 Partition wall
50 Tank
51 Engagement claw
52 Flow channel tube
53 Annular wall
60 Heater unit
61 Wick
62 Heating wire
62a Terminal portion
63 Support unit
63a First support body
63a1 Fitting groove
63a2 Penetration port
63b Second support body
63b 1 Annular groove
64 Heater holder
65 Heater cover
65a Opening portion
65b Engagement port
66 Seal member
70 Inflow port
71 Aspiratory port
73 Mesh opening
74 Filter
75 Abutment portion
75D Dividing line
76 Fixing claw
77 Guide wall
81 Screw
90 Ventilation port
91 Frame member
92 Support member
93 Recessed portion
94 Support portion
97 Reinforcing member
97a Penetration port
98 Seal member
100 Perpendicular disposition portion
101 First face
102 Second face
103 Connection port

## Claims

1. A power source unit of an aerosol generation device comprising:
a power source portion;
a flexible printed board electrically connected to the power source portion;
a sensor mounted on the flexible printed board; and
a housing accommodating at least the power source portion, the flexible printed board, and the sensor,
wherein the flexible printed board has a perpendicular disposition portion disposed in a manner of being substantially perpendicular to a longitudinal direction of the housing, and
wherein the sensor is mounted in the perpendicular disposition portion.

2. The power source unit of an aerosol generation device according to claim 1,
wherein a pin electrode is mounted on a second face of the perpendicular disposition portion on a side opposite to a first face on which the sensor is mounted.

3. The power source unit of an aerosol generation device according to claim 2,
wherein the sensor is a pressure sensor,
wherein the housing has an end wall supporting the pin electrode, and
wherein a ventilation port penetrating the housing in the longitudinal direction is formed in the end wall.

4. The power source unit of an aerosol generation device according to claim 3 further comprising:
a frame member that forms a pressure variation chamber in a gap between the end wall and the perpendicular disposition portion, the pressure variation chamber communicating with the ventilation port.

5. The power source unit of an aerosol generation device according to claim 4,
wherein a connection port is formed in the perpendicular disposition portion, the connection port penetrating the housing in the longitudinal direction and spatially connecting the pressure variation chamber and the sensor to each other.

6. The power source unit of an aerosol generation device according to claim 5 further comprising:
a support member disposed on the first face side of the perpendicular disposition portion and supporting at least a part of a rear surface region of the pin electrode.

7. The power source unit of an aerosol generation device according to any one of claims 1 to 6 further comprising:
a charging terminal for charging the power source portion; and
a substrate accommodated in the housing,
wherein the power source portion, the sensor, the charging terminal, and the substrate are electrically connected to the flexible printed board.

8. The power source unit of an aerosol generation device according to claim 7,
wherein the perpendicular disposition portion is disposed on a first end portion side of the housing in the longitudinal direction,
wherein the charging terminal is disposed on a second end portion side of the housing in the longitudinal direction, and
wherein the flexible printed board extends from the first end portion side to the second end portion side of the housing in the longitudinal direction.

9. A main body unit of an aerosol generation device comprising:
the power source unit of an aerosol generation device according to any one of claims 1 to 8; and
an accommodation portion being capable of accommodating an atomization unit configured to be electrically connected to the power source unit.

10. The main body unit of an aerosol generation device according to claim 9,
wherein the accommodation portion is an outer housing accommodating the housing of the power source unit or a part of the housing of the power source unit.

11. An aerosol generation device comprising:
the main body unit of an aerosol generation device according to claim 9 or 10; and
an atomization unit accommodated in the accommodation portion of the main body unit and is electrically connected to the power source unit.

12. A non-combustion-type aspirator comprising:
the aerosol generation device according to claim 11; and
an aroma source container mounted in a suction port portion of the aerosol generation device.
